## Europäisches Patentamt

## European Patent Office

## Office européen des brevets

(19)

(11) Veröffentlichungsnummer: **0 074 468**
**B1**

(12)

# EUROPÄISCHE PATENTSCHRIFT

(45) Veröffentlichungstag der Patentschrift:
16.01.85

(51) Int. Cl.⁴: **H 03 K 4/83**

(21) Anmeldenummer: **82105533.2**

(22) Anmeldetag: **24.06.82**

(54) **Schaltungsanordnung zur Erzeugung eines Ablenkstromes für die Vertikalablenkung des Elektronenstrahls in einem Fernsehempfänger.**

(30) Priorität: **10.09.81 DE 3135797**

(43) Veröffentlichungstag der Anmeldung:
**23.03.83 Patentblatt 83/12**

(45) Bekanntmachung des Hinweises auf die Patenterteilung:
**16.01.85 Patentblatt 85/3**

(84) Benannte Vertragsstaaten:
**BE FR GB IT NL SE**

(56) Entgegenhaltungen:
**EP - A - 0 008 263**
**GB - A - 1 299 049**
**US - A - 4 048 544**

(73) Patentinhaber: **Deutsche Thomson-Brandt GmbH, Hermann-Schwer-Strasse 3, D-7730 Villingen-Schwenningen (DE)**

(72) Erfinder: **Hartmann, Uwe, Ing. grad., Tallardstrasse 15, D-7730 Villingen-Schwenningen (DE)**

ACTORUM AG

## Beschreibung

Die Erfindung betrifft eine Schaltungsanordnung zur Erzeugung eines Ablenkstromes für die Vertikalablenkung des Elektronenstrahls in einem Fernsehempfänger. Es sind Vertikalablenkschaltungen bekannt, bei denen der sägezahnförmige Vertikalablenkstrom dadurch erzeugt wird, dass ein gesteuerter Schalter in Reihe mit einer Wicklung des Zeilentransformators gelegt ist, an deren anderen Ende über eine Induktivität die Ablenkwicklung in Reihe mit einem Koppelkondensator und einem Strommesswiderstand nach Masse geschaltet ist. Der gesteuerte Schalter wird mit impulsbreitenmodulierten zeilenfrequenten Impulsen getaktet (europäische Patentanmeldung Nr. 0008263). Bei der dort beschriebenen Schaltung ist der Koppelkondensator derart gross gewählt, dass die sich an diesem ausbildende Gleichspannung konstant bleibt und immer die gleiche Polarität besitzt, unabhängig von der Richtung des durch die Ablenkspule fliessenden Ablenkstromes. Am Verbindungspunkt von Ablenkwicklung mit dem Koppelkondensator kann eine Spannung für eine Gleichspannungsgegenkopplung zwecks Arbeitspunktstabilisierung abgenommen werden, während am Strommesswiderstand eine dem Ablenkstrom entsprechende Wechselstromgegenkopplung zwecks Linearisierung des Ablenkstromes entnommen wird. Dies bedeutet zwei getrennte Rückführungen. Eine Gleichstromkomponente zur Bildlagekorrektur ist nur über eine ausgangsseitige Einspeisung mit schlechtem Wirkungsgrad möglich. Der Strom für die Bildlageverschiebung muss einem Potentiometer entnommen werden, welches Leistung verbraucht.

Durch die Verwendung des Koppelkondensators im Ablenkkreis zeigt dieser durch die dadurch sich ergebende Zeitkonstante ein nachteiliges Einschwingverhalten, was sich insbesondere bei der Kanalumschaltung bemerkbar macht (*bouncing*-Effekt).

Der Erfindung liegt die Aufgabe zugrunde, diesen Einschwingeffekt zu beseitigen. Sie bringt den Vorteil, dass ausserdem durch Fortfall des Kondensators der negative Einfluss auf die Linearität der Ablenkung wegfällt, so dass die Linearitätstoleranzen klein und auf lange Zeit konstant bleiben. Durch die Gleichstromkopplung kann eine sehr einfache, mit gutem Wirkungsgrad arbeitende Bildlagejustierung erreicht werden, so dass die gesamte Schaltung durch Wegfall einer gesonderten Linearitätseinstellung durch Einsparung des Koppelkondensators und durch die einfachere Bildlageverschiebung sehr kostengünstig gestaltet werden kann.

### Beschreibung

Nachstehend wird das Wesentliche der Erfindung an einem Ausführungsbeispiel mit Hilfe der Zeichnung erläutert.

Fig. 1 zeigt das Schaltungsprinzip der Erfindung in einem Blockschaltbild;

Fig. 2 zeigt Einzelheiten der Schaltung nach Fig. 1.

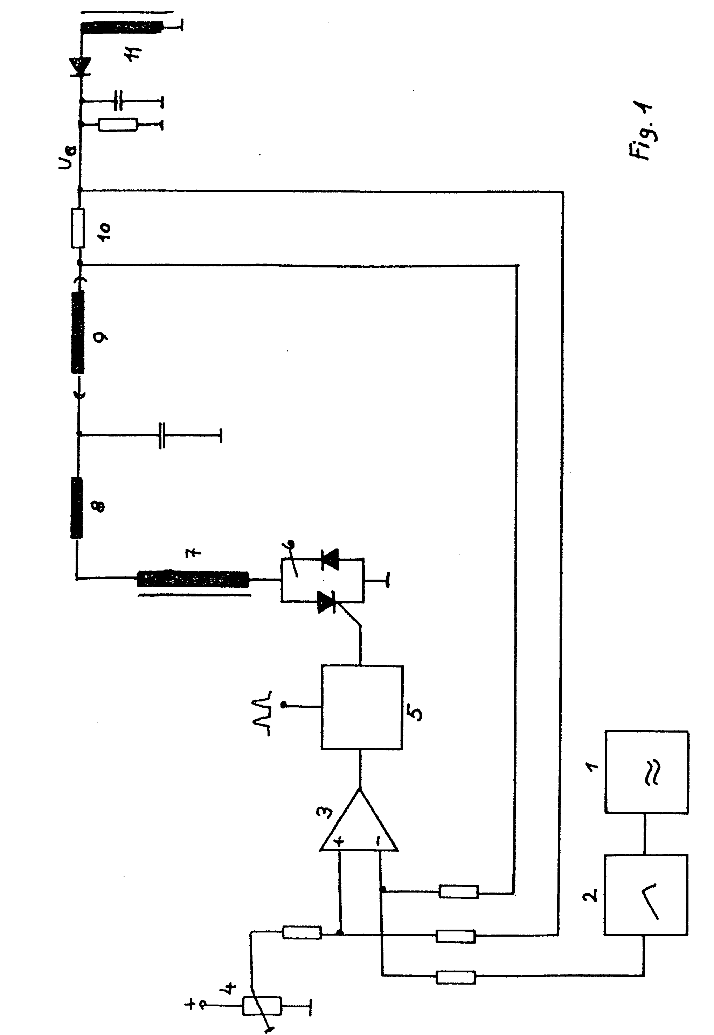

In Fig. 1 werden die mit Hilfe eines Oszillators 1 erzeugten Impulse in einem Sägezahngenerator 2 zu vertikalfrequenten Sägezahnsignalen umgeformt. Dieses Signal gelangt auf den invertierenden Eingang des Differenzverstärkers 3. Der Ausgang des Differenzverstärkers 3 steuert einen Pulsbreitenmodulator 5 an, der diesem zugeführte zeilenfrequente Impulse in ihrer Breite moduliert. Diese modulierten Impulse werden an die Steuerelektrode des elektronischen Schalters 6 gelegt, der in Reihe mit einer Wicklung 7 des Zeilentransformators geschaltet ist. Über die Induktivität 8 ist die Vertikalablenkwicklung 9 über den Strommesswiderstand 10 an eine positive, durch Gleichrichtung aus der Zeilentransformatorwicklung 11 gewonnene Betriebsspannung $U_B$ des Fernsehempfängers angeschlossen. An dem Strommesswiderstand 10 wird eine Spannung abgenommen – und dem invertierenden Eingang des Differenzverstärkers 3 zugeführt –, die gegenphasig zu der anliegenden vertikalfrequenten Sägezahnspannung ist. Das andere, auf dem Betriebsspannungspotential $U_B$ liegende Ende des Strommesswiderstandes 10 ist an den nichtinvertierenden Eingang des Differenzverstärkers 3 gelegt. Die Bildlage kann mit Hilfe eines an den Differenzverstärker 3 geschalteten Stellwiderstandes 4 verändert werden.

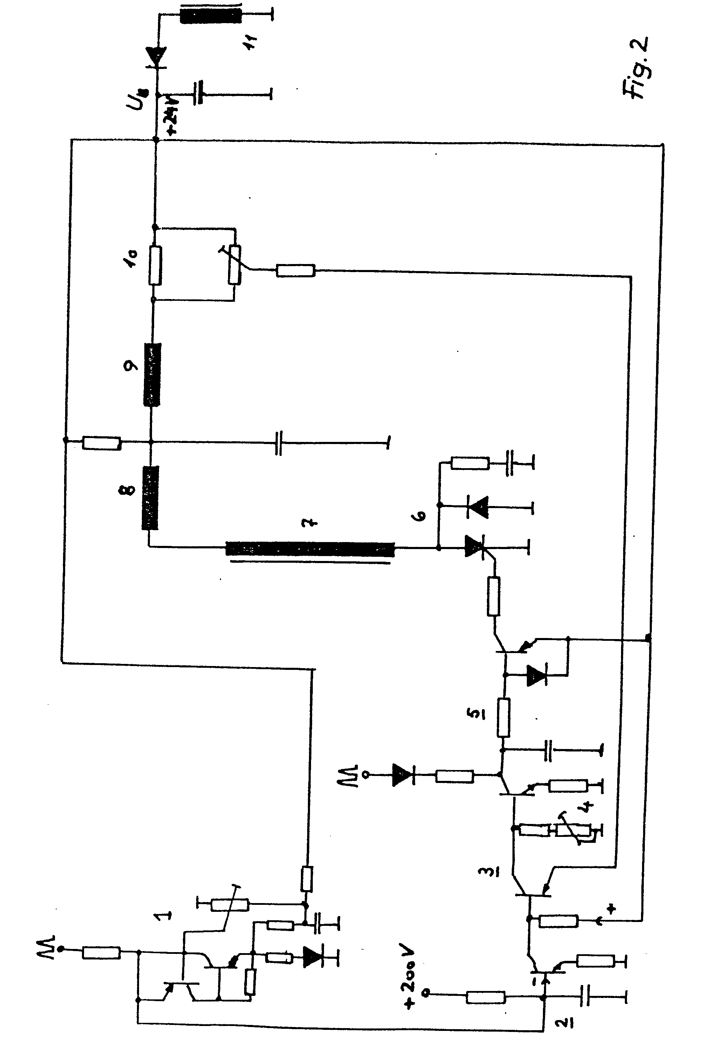

In Fig. 2 ist ein detailliertes Schaltbild der Erfindung wiedergegeben, in welcher die entsprechenden Blöcke der Fig. 1 mit gleichen Bezugsziffern versehen sind.

### Patentanspruch

Schaltungsanordnung zur Erzeugung eines Ablenkstromes für die Vertikalablenkung (9) des Elektronenstrahls in einem Fernsehempfänger, wobei der Ablenkstrom aus einer Wicklung (7) des Zeilentransformators gewonnen wird, die mit einem gesteuerten elektronischen Schalter (6) in Reihe nach Masse geschaltet ist, welchem eine Diode antiparallel liegt, mit einer an das andere Ende der Wicklung (7) des Zeilentransformators über ein integrierendes Netzwerk (8) angeschlossenen Vertikalablenkwicklung (9) und einem zu dieser Wicklung (9) in Reihe geschalteten Strommesswiderstand (10) sowie mit einer Steuerschaltung (5), die von einem Vertikaloszillator (1) und einem Sägezahngenerator (2) das Ablenksignal erhält und die zeilenfrequenten, vertikalfrequent breitenmodulierten Impulse für den gesteuerten Schalter (6) erzeugt, dadurch gekennzeichnet, dass der Strommesswiderstand (10) mit seinem der vertikalen Ablenkwicklung (9) abgewandten Ende an ein positives, als Versorgungsspannung $U_B$ im Fernsehempfänger vorhandenes Potential angeschlossen ist, und dass das mit der Ablenkwicklung (9) verbundene Ende des Strommesswiderstandes (10) an den invertierenden Eingang (–) eines Differenzverstärkers (3) gelegt ist, welchem ein vertikalfrequentes sägezahnförmiges Signal zugeführt wird, und dass das andere Ende des Strommesswiderstandes (10) an den nichtinvertierenden Eingang (+) des Differenzverstärkers (3) geschaltet ist, dessen Ausgang an den Eingang der Steuerschaltung (5) angeschlossen ist.

## Claim

Circuit arrangement for the generation of a deflection current for the vertical deflection of the electron beam in a TV receiver, whereby the deflection current is gained from a winding (7) of the line transformer, which is switched in series with a controlled electronic switch (6) to ground, to which a diode lies antiparallel, with a vertical-deflection winding (9) connected to the other end of the winding (7) of the line transformer, *via* an integrated network (8), and a current-measuring resistance (10) connected in series to this winding (9), as well as with a control circuit (5), which receives the deflection signal from a vertical oscillator (1) and a saw-tooth generator (2) and generates the line-frequent, vertical-frequent width-modulated pulses for the control switch (6), characterized in that the current-measuring resistance (10) with its opposed end to the vertical-deflection winding (9) is being connected to a positive potential, which is available as supply voltage ($U_B$) in the TV receiver, and in that the end of the current-measuring resistance (10), which is connected to the deflection winding (9), is being laid to inverting input (−) of a difference amplifier (3), which is being supplied with a vertical-frequent saw-tooth-shaped signal, and in that the other end of the current-measuring resistance (10) is connected to the non-inverting input (+) of the difference amplifier (3), whose output is joined with the input of the control circuit (5).

## Revendication

Circuit pour produire un courant de déviation pour le circuit de déviation verticale du faisceau électronique d'un récepteur de télévision, ce courant étant obtenu d'un enroulement (7) d'un transformateur de lignes dont l'extrémité est reliée à la masse à travers un commutateur à commande électronique (6), sur lequel est branchée en antiparallèle une diode, ce circuit comprenant une bobine de déviation verticale (9) connectée à l'autre extrémité de l'enroulement (7) du transformateur de lignes à travers un réseau d'intégration (8) et une résistance de mesure d'intensité (10) en série avec ledit enroulement (9), ainsi qu'un circuit de commande (5) qui reçoit le signal de déviation d'un oscillateur vertical (1) et d'un générateur de tension en dents de scie (2) et qui produit les impulsions de commande du commutateur (6), ces impulsions étant à la fréquence de déviation horizontale et modulées en largeur à la fréquence de déviation verticale, caractérisé en ce que l'extrémité de la résistance de mesure d'intensité (10) opposée à l'enroulement de déviation verticale (9) est connectée à un potentiel positif présent en tant que tension d'alimentation ($U_B$) dans le récepteur de télévision, et en ce que l'extrémité de la résistance de mesure (10) reliée à l'enroulement de déviation (9) est connectée à l'entrée inverseuse (−) d'un amplificateur différentiel (3) auquel est également appliqué un signal en dents de scie à la fréquence de déviation verticale, et en ce que l'autre extrémité de la résistance de mesure (10) est connectée à l'entrée non inverseuse (+) de l'amplificateur différentiel (3), dont la sortie est connectée à l'entrée du circuit de commande (5).

Fig. 1

Fig. 2

0 074 468